# DEMANDE DE BREVET EUROPEEN

(11) **EP 1 748 493 A1**
(43) Date de publication de la demande: **31.01.2007**
(21) Numéro de dépôt: 06117667.3
(22) Date de dépôt: 21.07.2006
(51) Int. Cl.: H01L 29/78

(54) **Cellule mémoire à un transistor à corps isolé à sensibilité de lecture améliorée**

(30) Priorité: 26.07.2005 FR 0552307
(71) Demandeur: STMicroelectronics S.A., 38926 Crolles cedex (FR)
(72) Inventeur: Villaret, Alexandre, 38000, Grenoble (FR); Mazoyer, Pascale, 38420, Domène (FR); Ranica, Rossella, 38000, Grenoble (FR)
(74) Mandataire: de Beaumont, Michel

(57) **Abrégé**

L'invention concerne une cellule mémoire à un transistor MOS formé dans une région de corps flottant (1) isolée sur sa face inférieure par une jonction. Une région (41) du même type de conductivité que la région de corps flottant mais plus fortement dopée que celle-ci est disposée sous la région de drain (10) du transistor MOS.

## Description

### Domaine de l'invention

La présente invention concerne des cellules mémoire de type DRAM à un transistor formé dans un caisson ou corps flottant délimité dans le sens de la profondeur par une jonction.

### Exposé de l'art antérieur

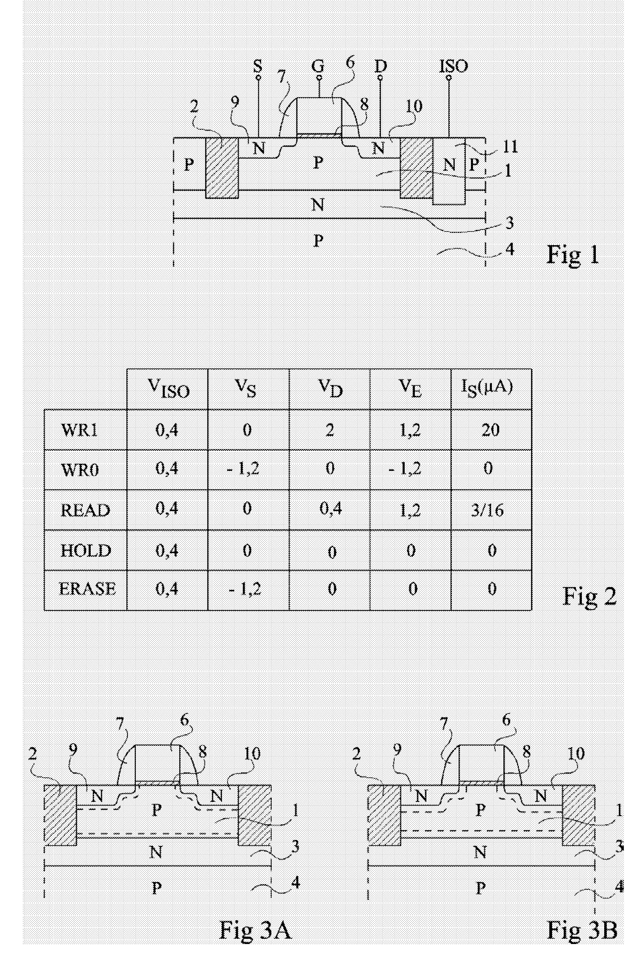

La figure 1 est une vue en coupe schématique d'un exemple d'une telle cellule mémoire. Cette cellule comprend un transistor MOS à canal N formé dans une région de corps flottant 1 délimitée latéralement par un anneau isolant 2 et, dans le sens de la profondeur, par une couche 3 de type N formée dans un substrat 4 de type P. Le transistor MOS comprend, de part et d'autre d'une région de grille 6 entourée d'espaceurs 7 et reposant sur un isolant de grille 8, des régions de source et de drain 9 et 10 de type N. Chacune des régions de source et de drain comprend une région plus dopée et plus profonde à l'extérieur de la région définie par les espaceurs 7 et une région moins dopée et moins profonde sous les espaceurs 7.

En l'absence d'action spécifique sur la cellule, le corps flottant 1 est à un potentiel donné correspondant à l'équilibre thermodynamique. Il a été montré que l'on pouvait injecter dans ce corps des charges positives ou négatives, mettant la cellule dans l'un ou l'autre de deux états déterminés que l'on appellera 1 et 0. En fonction de cette polarisation du substrat, la tension de seuil du transistor se modifie et l'on peut donc distinguer les états 1 et 0.

En outre, la figure 1 représente un puits conducteur 11 de type N rejoignant la couche enterrée 3 pour permettre de la polariser. Dans la figure, la borne de polarisation est appelée ISO, la couche enterrée 3 pouvant être appelée couche d'isolement.

La figure 2 est un tableau illustrant les tensions à appliquer à la cellule dans divers modes de fonctionnement de celle-ci. On a plus particulièrement indiqué les tensions VISO à appliquer sur la couche enterrée 3, VS à appliquer sur la source, VD à appliquer sur le drain, et VG à appliquer sur la grille. Dans la colonne de droite, on a indiqué le courant de conduction du transistor mesuré dans ces divers états, désigné par IS et exprimé en microampères alors que toutes les tensions sont exprimées en volts. Plus particulièrement, on a distingué des états d'écriture d'un 1 (WR1), d'écriture d'un 0 (WR0), de lecture (READ), de maintien ou rétention (HOLD), et d'effacement (ERASE). Les valeurs données dans ce tableau le sont uniquement à titre d'exemple et correspondent à une technologie particulière. On retiendra essentiellement les valeurs relatives des diverses tensions et leurs polarités. L'exemple donné correspond à une technologie dans laquelle la dimension minimum possible d'un motif est de l'ordre de 0,12 µm, dans laquelle on a choisi une longueur de grille de l'ordre de 0,30 µm et une profondeur des régions d'isolement STI 2 de l'ordre de 0,35 µm ainsi qu'une épaisseur d'oxyde de grille de l'ordre de 6 nm.

Ainsi, les principaux états de la cellule sont les suivants.
- Ecriture d'un 1 (WR1). Le transistor MOS est mis dans un état de conduction relativement fort (courant de l'ordre de 20 µA). Cet état peut n'être établi que pendant une très brève durée, par exemple de l'ordre de quelques nanosecondes. A la fin de cet état, quand toutes les tensions appliquées sont ramenées à zéro, sauf la tension de couche enterrée qui est maintenue de préférence à une valeur faiblement positive par exemple 0,4 volt, la cellule mémoire est dans l'état illustré en figure 3A, à savoir que des charges positives se sont accumulées dans le corps flottant. Une fois la cellule mémoire à l'état d'équilibre thermodynamique, ces charges tendent, comme cela est illustré, à rétrécir les zones de charge d'espace. Le transistor a alors une tension de seuil faible, c'est-à-dire que, si l'on se met dans un état de lecture dans lequel le transistor est faiblement polarisé à l'état passant, on observera pour une tension de grille donnée un premier courant (16 pA dans l'exemple illustré).
- Ecriture d'un 0 (WR0). Le transistor est bloqué, sa grille étant mise à un potentiel négatif, et sa source (ou son drain) est également mis à un potentiel négatif, d'où il résulte que les charges positives éventuellement présentes dans le substrat sont éliminées et que des charges négatives sont injectées par suite de la mise à l'état passant de la diode corps-source ou corps-drain. A la fin de cet état, de la façon illustrée en figure 3B, les zones de charge d'espace ont tendance à s'élargir et ceci entraîne que la tension de seuil du transistor augmente. Ainsi, si l'on se met dans des conditions de lecture dans lesquelles le transistor est faiblement polarisé à l'état passant, on obtient pour une même tension de grille de 1,2 V que celle considérée dans le cas précédent, un courant plus faible que le courant à l'état 1 (3 pA au lieu de 16 pA dans l'exemple illustré).
- Lecture (READ). Le transistor MOS est mis dans un état faiblement passant, le drain étant par exemple seulement à une tension de l'ordre de 0,4 V pour limiter les injections susceptibles de déprogrammer le transistor. Le courant traversant le transistor MOS est mesuré ou, de préférence, comparé à une valeur de référence comprise entre les valeurs de courant correspondant aux états 1 et 0.
- Maintien (HOLD). Aucune tension n'est appliquée au transistor. La tension appliquée à la couche enterrée 3 est de préférence maintenue légèrement positive pour mieux bloquer la jonction entre le corps isolé et cette couche enterrée dans le cas où le transistor est programmé à l'état 1.
- Effacement (ERASE). La jonction source/corps (ou drain/corps) est polarisée dans le sens passant ce qui permet l'évacuation des charges positives. La couche enterrée 3 reste faiblement polarisée positivement.

Ainsi, comme on l'a exposé précédemment, l'effet mémoire d'une cellule selon la présente invention se caractérise par une différence entre un courant à l'état 1 et un courant à l'état 0 pour une polarisation drain-source donnée et pour une tension de grille donnée.

De façon générale, pendant la phase de lecture, on compare le courant détecté correspondant à un état 1 (I1) ou à un état 0 (I0) à un courant de référence I_{ref}. Le courant de référence I_{ref} est généralement choisi égal à la moyenne (I1+I0)/2 de I1 et I0. Toutefois, étant donné qu'il y a une certaine dispersion d'une cellule à l'autre sur les valeurs de I1 et I0 en fonction de la technologie et que, de plus, les valeurs I1 et I0 sont susceptibles de varier, notamment en fonction de la durée d'utilisation des cellules, la lecture risque d'être entachée d'erreur.

### Résumé de l'invention

Un objet de la présente invention est d'améliorer la sensibilité en lecture.

Pour atteindre cet objet, la présente invention prévoit une cellule mémoire à un transistor MOS formé dans une région de corps flottant isolée sur sa face inférieure par une jonction, dans laquelle une région du même type de conductivité que la région de corps flottant mais plus fortement dopée que celle-ci est disposée sous la région de drain du transistor MOS.

Selon un mode de réalisation de la présente invention, la région de drain comprend une région de contact de drain et une région d'extension de drain plus faiblement dopée du côté de la grille, et la région du même type de conductivité que la région de corps flottant s'étend sous la région de contact de drain et de façon adjacente à celle-ci.

Selon un mode de réalisation de la présente invention, la région de corps flottant a un niveau de dopage de l'ordre de 10¹⁷ at./cm³, et la région du même type de conductivité que la région de corps flottant est une région enterrée ayant un dopage moyen de l'ordre de 5.10¹⁷ à 10¹⁹ at./cm³.

La présente invention prévoit aussi un procédé de fabrication d'une cellule telle que susmentionnée dans lequel ladite région du même type de conductivité que la région de corps flottant résulte d'une implantation oblique réalisée après formation de la grille du transistor MOS, l'orientation de la tranche par rapport à la direction d'implantation étant choisie pour que la grille masque sensiblement l'implantation côté source.

La présente invention vise aussi un circuit intégré comprenant au moins une cellule mémoire telle que susmentionnée.

### Brève description des dessins

Cet objet, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente une cellule mémoire à un transistor sur caisson flottant ;
la figure 2 est un tableau illustrant des exemples de tensions appliquées à la cellule de la figure 1 dans différents états ;
la figure 3A représente la structure de la figure 1 dans l'état de maintien après écriture d'un état 1 ;
la figure 3B représente la structure de la figure 1 dans l'état de maintien après écriture d'un état 0 ;
les figures 4A et 4B représentent deux ensembles distincts de courants à l'état 1 et à l'état 0 ;
la figure 5 est une vue en coupe schématique d'une cellule mémoire selon un mode de réalisation de la présente invention ; et
la figure 6 représente un exemple d'une étape de fabrication de la cellule mémoire selon la présente invention.

Comme cela est habituel dans la représentation des circuits intégrés, les diverses vues en coupe ne sont pas tracées à l'échelle.

### Description détaillée

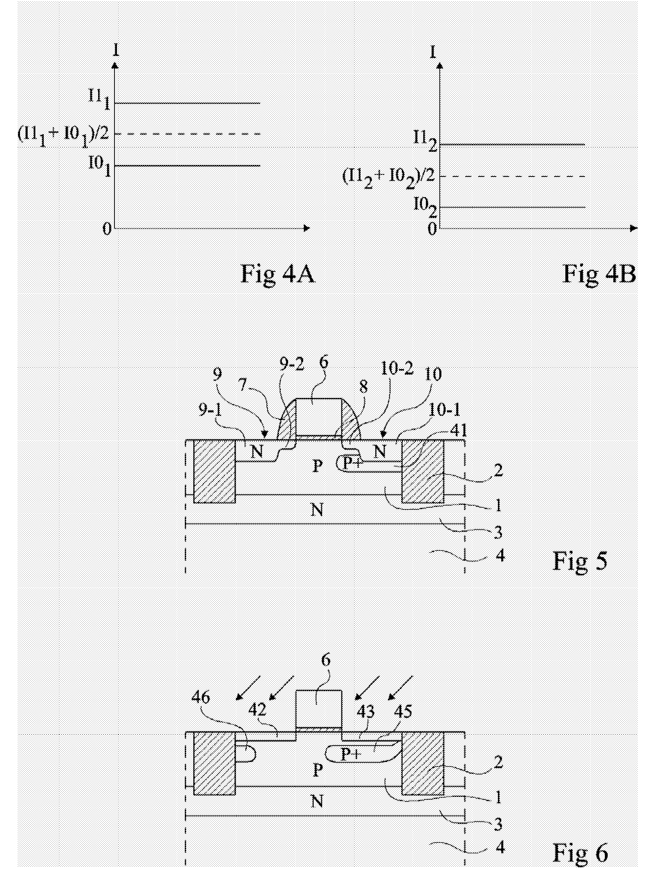

Des études statistiques effectuées sur des modèles de cellules montrent que le risque d'erreur de lecture (confusion d'un 1 et d'un 0 ou non détection d'un 1 ou d'un 0) diminue, pour une différence I1-I0 donnée, avec la valeur moyenne de I1+I0, c'est-à-dire avec la valeur de I_{ref}. Ainsi, le risque d'erreur de lecture est plus faible dans le cas de la figure 4B que dans le cas de la figure 4A.

Les inventeurs ont donc recherché à réaliser une cellule mémoire à un transistor à région de corps flottant dans laquelle l'écart I1-I0 est sensiblement non modifié par rapport à une cellule classique telle que celle de la figure 1 mais dans laquelle les valeurs de I1 et I0 sont réduites.

Les inventeurs ont montré que ce résultat était obtenu si le dopage de la région de corps flottant 1 sous la région de drain était augmenté. Ainsi, les inventeurs proposent, comme cela est représenté en figure 5, de réaliser sous la région de drain 10 une région 41 de type P plus fortement dopée que le reste de la région de corps flottant. L'expérience a montré que ceci donnait des résultats satisfaisants, les courants de lecture à l'état 0 et à l'état 1 étant tous les deux réduits de quelques microampères. Une explication de ce résultat est que, du fait du dopage plus élevé de la région de type P sous le drain, la zone de charge d'espace (non représentée) s'étend davantage dans la région de drain de type N. Ceci entraîne que la largeur de canal effective entre source et drain augmente et donc que, pour une tension de grille donnée, le courant de lecture diminue.

De plus, on notera que la représentation de la région plus fortement dopée 41 est purement illustrative, l'étendue de cette zone et sa remontée vers la région d'extension de drain dépendant des conditions d'implantation et de recuit.

En figure 5, on a utilisé les mêmes références qu'en figure 4. Toutefois, dans la région de source 9, on a distingué une région de contact de source 9-1 et une région d'extension de source 9-2, plus faiblement dopée, sous l'espaceur 7. De même, dans la région de drain 10, on a distingué une région de contact de drain 10-1 et une région d'extension de drain 10-2, plus faiblement dopée, sous l'espaceur 7. La région 41 est de préférence située sous la région de contact de drain 10-1 et est adjacente à celle-ci, sans remonter dans la région de canal sous la grille 6.

L'homme de l'art saura sans difficulté fabriquer une structure du type de celle de la figure 5. Par exemple, la région 41 pourrait être formée après réalisation de la grille et avant (ou après) réalisation des espaceurs en masquant une moitié de la structure par un masque s'arrêtant sur la grille et en réalisant une implantation d'ions dopants de type P, par exemple du bore. Dans le cas où la région de corps flottant 1 a un niveau de dopage de l'ordre de 10¹⁷ at./cm³, la région 41 sera une région enterrée ayant un dopage moyen de l'ordre de 5.10¹⁷ à 10¹⁹ at./cm³.

Un autre procédé de réalisation de la région 41 est illustré en figure 6. On part d'un substrat 4 de type P dans lequel on a défini une région active par des tranchées peu profondes 2 remplies d'un isolant. On considère une étape à laquelle on a formé la grille 6 sur son isolant de grille 8 et où on a réalisé des régions 42 et 43 qui correspondront aux régions d'extension de source et de drain. On procède alors à une implantation oblique d'atomes de bore avec une énergie d'implantation choisie pour que la région implantée se situe nettement sous les régions 42 et 43. Du côté drain, on obtient une région 45 qui s'étend largement autour du drain, et qui demeurera autour du drain même une fois que les régions de drain plus fortement dopées seront implantées après réalisation des espaceurs. Du côté source, l'implantation oblique est majoritairement masquée par la grille 6. Eventuellement, une petite zone désignée par la référence 46 sera implantée à gauche sur la figure. Toutefois, cette implantation est peu gênante d'autant plus qu'elle sera partiellement gommée par l'implantation à forte dose de type N réalisée par la suite pour former la région de contact de source.

La présente invention est susceptible de diverses variantes et modifications qui apparaîtront à l'homme de l'art. Notamment, les divers matériaux utilisés et les dimensions indiquées pourront être modifiés selon la technologie utilisée, du moment que les fonctions décrites sont atteintes.

## Revendications

1. Cellule mémoire à un transistor MOS formé dans une région de corps flottant (1) isolée sur sa face inférieure par une jonction, **caractérisée en ce qu'**une région (41 ; 45) du même type de conductivité que la région de corps flottant mais plus fortement dopée que celle-ci est disposée sous la région de drain (10) du transistor MOS.

2. Cellule mémoire selon la revendication 1, dans laquelle la région de drain comprend une région de contact de drain et une région d'extension de drain plus faiblement dopée du côté de la grille, et dans laquelle ladite région (41) du même type de conductivité que la région de corps flottant s'étend sous la région de contact de drain et de façon adjacente à celle-ci.

3. Cellule mémoire selon la revendication 1, dans laquelle la région de corps flottant (1) a un niveau de dopage de l'ordre de 10¹⁷ at./cm³, et la région (41 ; 45) du même type de conductivité que la région de corps flottant est une région enterrée ayant un dopage moyen de l'ordre de 5.10¹⁷ à 10¹⁹ at./cm³.

4. Procédé de fabrication d'une cellule selon la revendication 1, dans lequel ladite région (45) du même type de conductivité que la région de corps flottant résulte d'une implantation oblique réalisée après formation de la grille (6) du transistor MOS, l'orientation de la tranche par rapport à la direction d'implantation étant choisie pour que la grille masque sensiblement l'implantation côté source.

5. Circuit intégré comprenant au moins une cellule mémoire selon la revendication 1.
